# EUROPEAN PATENT APPLICATION

(11) **EP 1 867 696 A1**
(43) Date of publication of application: **19.12.2007**
(21) Application number: 06712465.1
(22) Date of filing: 27.01.2006
(51) Int. Cl.: C09K 11/61, C09K 11/00, G01T 1/20, G01T 1/202

(54) **HIGH COUNTING RATE SCINTILLATOR**

(30) Priority: 14.02.2005 JP 2005036068
(71) Applicant: Japan Science and Technology Agency, Kawaguchi-shi, Saitama 332-0012 (JP)
(72) Inventor: KOSHIMIZU, Masanori, Miyagi, 9830833 (JP); SHIBUYA, Kengo, Chiba 2730003 (JP); SAITO, Haruo, Tokyo 14000002 (JP); ASAI, Keisuke, Sendai-shi Miyagi, 9800861 (JP); HONDA, Tsuneo, Chiba, 2720804 (JP)
(74) Representative: Wilson Gunn
(86) International application number: PCT/JP2006/301299
(87) International publication number: WO 2006/085442

(57) **Abstract**

[PROBLEMS] To provide a scintillator responding to high counting rate sustaining high-speed and high detection efficiency of BaF₂ and to provide a radiation detection device with high time resolution by using the scintillator.

[MEANS FOR SOLVING PROBLEMS] A specified amount of rare earth element (Eu) is doped into BaF₂ to reduce long decay lifetime component (600 to 620 nm), leaving fast decaying component (0.6 to 0.8 ns) of BaF₂ luminescence unchanged. The present invention is a high counting rate scintillator for detecting radiation comprising BaF₂ doped with rare earth elements (Eu), wherein the doping amount is in the range of 0.02 to 1.0 mol%.

## Description

### Field of the Invention:

The present invention relates to a scintillator for detecting ionizing radiation and in particular, relates to a gamma-ray scintillator and a detection device with an extremely rapid time resolution.

### Prior Art:

Enough time resolution has not been obtained in conventional gamma-ray detector, especially in detecting positron annihilation lifetime (0.511 MeV PAL). Time resolution is greatly important in practical application. For example, improvement of time resolution of positron emission tomography (PET) in medical practice leads to improvement of detection accuracy of positron annihilation point based on time information, and consequently, brings about reduction of subject obligation by shortage of measuring time and by reduction of source intensity. Furthermore, since positron annihilation lifetime measurement is applied to detection of lattice defect in material science, improvement of time resolution results in improvement of detection sensitivity.

It is essential to use scintillator crystal including fluorescent component with shorter decay lifetime than conventional one to improve time resolution of the gamma-ray detector. However, most of the scintillator crystal in previous practical use involves crystals with high luminescence quantum yield but with slow fluorescent decay time constant as several hundreds nanoseconds (NaI(Tl), CsI(Tl), CsI(Tl), CsI(Na), BGO, CdWO and the like) or those with fast decay constant as several to 30 nanoseconds but with low luminescence quantum yield (CsF, CeF₃, CsI, organic scintillator and the like).

Among various scintillators in practical use, only barium fluoride (BaF₂) has decay constant with sub-nanoseconds (0.6 to 0.8 nanoseconds) (Reference 1). However, the handling is very difficult, because very short (i.e. 225 nm) wavelength of the fast decaying fluorescent component necessitates the use of an expensive detector for ultraviolet wavelength.

In contrast, there is an example of scintillator prepared by doping Eu to the barium fluoride (BaF₂). However, the fast decaying component (decay constant with 0.6 to 0.8 nanoseconds) has not been detectable (Reference 2).
Reference 1: M. Laval et al., Nucl. Instm. Meth., 206 (1983) 169.
Reference 2: IEEE Transaction on Nuclear Science, vol36, No. 1, 1989, p.536.

### Problem to be solved by the invention:

A scintillator having a high time resolution and a high detection efficiency is very important for Positron Emission Tomography (PET) in medical practice and in Positron Annihilation Lifetime measurement in material science. Furthermore, performance required for a scintillator involves a high counting rate, i.e. a high measurable number of ionizing radiation in a unit time.

A BaF₂ scintillator presently in pervasive use has a high time resolution and a high detection efficiency. However, more than 80 % of the luminescence from BaF₂ involves long decay lifetime components with 600 to 620 ns. Therefore, a large number of incident radiation leads to wave overlapping and does not respond to high counting rate.

An objective of the present invention is to provide a scintillator responding to high counting rate sustaining high-speed and high detection efficiency of BaF₂ and to provide a radiation detection device with high time resolution by the use of the scintillator.

### Means to solve the Problems:

Since Auger-free luminescence from BaF₂, a fast decaying component (0.6 to 0.8 ns), is caused by core-level excitation and is expected to be insensitive to impurity dope, the present inventors changed the amount of long decay lifetime components (600 to 620 ns) leaving Auger-free luminescence unchanged by changing the doping amount of impurity (Eu), and found the resulted scintillator has a reduced long decay lifetime component then accomplished the present invention.

In other words, the present invention is a high counting rate scintillator for detecting radiation, comprising BaF₂, doped with rare earth elements, wherein the doping amount is in the range of 0.02 to 1.0 mol%.

The relative intensity of the long decay lifetime component with more than 100 ns of said scintillator is preferably less than 50% of the total intensity of BaF₂ luminescence.

The time resolution of said scintillator is preferably less than 200 ps of half bandwidth.

The present invention is also a radiation detection device comprising the scintillator and a photomultiplier for detecting a luminescence from said scintillator.

### Effects of the Invention:

Radiation detecting technique with high time resolution is required for the measurement of positron lifetime and time dependent scattered radiation intensity and is indispensable in various material analysis techniques and radiation detection devices. The high counting rate scintillator of the present invention is obtained by eliminating long decay lifetime component of BaF₂ scintillator without impairing necessary time resolution. The radiation detection device could be not only addressed to detection of radiation with much stronger intensity, but also expected in extensive shortening of measuring time in various analysis devices.

### Brief Description of the Drawings:

Figure 1 shows the configuration of the measuring system used in Examples.
Figure 2 shows the result of the measurement in Example 1. The horizontal axis represents the number of channel (time) and the vertical axis represents the number of counts. The peak value is normalized to 1 in the vertical axis.
Figure 3 shows the distribution of wavehight.
Figure 4 shows the time spectrum.

### Detailed Description of the Invention:

BaF₂ luminescence is composed of two components of luminescence, i.e. fast decaying component (time constant is about 800 ps) and long decay lifetime component (time constant is about 600 ns). The long decay lifetime component, dominating the most part of the BaF₂ luminescence, is luminescence from self-trapped state with lattice distortion and the wavelength peak of the luminescence is 310 nm. In contrast, the fast decaying component is luminescence arising not from valence electron excitation but from transition of core electron. It is called as Auger-free luminescence. Auger-free luminescence is a possible process if the energy gap between valence electron band and inner-shell band is smaller than forbidden bandwidth and is taken place by the transition of an electron in valence band to the hole caused by excitation of an electron in outermost-core band by radiation. The luminescence is characterized by extremely fast decay, ultraviolet radiation and least temperature dependence. Wavelength of BaF₂ luminescence by the transition is 220 nm.
The BaF₂ crystal doped with Eu of the present invention has similar luminescence property.

The appropriate method for preparing the scintillator crystal of the present invention is vertical Bridgman method able to prepare a large-scale single crystal. The method enables to prepare crystal by getting slowly down a vertically long crucible enclosed with basic ingredient of crystal into a vertical furnace (crystal growth furnace) with specified temperature gradient and by solidifying from the bottom of melt in the crucible.

Then, the BaF₂ crystal was doped with metal such as Eu and the like. A general method for doping is mixing doping metal powder (e.g. Eu) with basic ingredient powder of BaF₂ followed by stirring. The mixture was enclosed in the crucible and subjected to heat treatment as in preparing BaF₂ crystal. In this way, a doped BaF₂ crystal is prepared.

The doping metal is rare earth element and is specifically Sc, Y or lanthanoid element (La to Lu). In the present invention, the doping metal is preferably lanthanoid element and more preferably Eu.

The doping amount in BaF₂ is preferably in the range of 0.02 to 1.0 mol%, more preferably 0.05 to 1.0 mol% and most preferably 0.05 to 0.2 mol%. The above amount is compatible with the result that 0.02 mol% has little suppressive doping effect on long decay lifetime component, which is shown later. Furthermore, it is generally known that luminescence intensity by doping decays exponentially with dope concentration. Consequently, the upper limit 1.0 mol% is determined by an experimental result that the intensity of the fast decaying component at 0.2 mol% dope concentration is 60% of the intensity of pure BaF₂ and by the estimation that the intensity of the fast decaying component at 1.0 mol% (5 times of 0.2 mol%) dope concentration is 7.8% of that of pure BaF₂ because of (0.6)⁵=0.078. Since 7.8% is lower than the lower limit (about 10% of the pure BaF₂ luminescence) of the intensity practically required for high time resolution scintillator, 1.0 mol% is determined as the upper limit.

Barium fluoride (BaF₂) crystal irradiated by gamma radiation emits fluorescence composed of fast decaying component (time constant: about 800 ps) and long decay lifetime component (time constant: about 600 ns). Present invention needs to use photomultiplier to detect fast decaying component light with 225 nm wavelength. Photomultiplier is composed of photoelectric surface for converting light into electrons and amplifier to amplify the electrons.

Since the luminescent component of the scintillator of the present invention is 225 nm and extremely short wavelength, the photomultiplier for use should have a window material with UV glass or synthetic quarts. Similarly, photoelectric surface material should be selected from those for this wavelength region. The combination of the above photomultiplier and the scintillator of the present invention is expected to offer a radiation detection device with high time resolution.

The radiation detection device of the present invention may be constructed not only by the above scintillator and photomultiplier but also by combination of these parts and an apparatus with appropriate specification for detecting radiation. For examples, a digital oscilloscope could be combined with the above crystal and photomultiplier, and the digital oscilloscope may be responded by an external trigger circuit. Furthermore, appropriate conventional apparatus could be used for processing detected waveforms.

Previously constant fraction discriminator (CFD), time-amplitude converting circuit (TAC), multi-channel analyzer (MCA) have been used for radiation time measurement by the use of concurrent number representation system. In contrast, the present invention performs the analysis of time difference by saving a wave profile output from photomultiplier in high-speed digital oscilloscope, converting the wave profile into a number and transferring the number to a personal computer instead of the above apparatuses. This is a method developed by the present inventors (Reference 1). Measurement with extremely high time resolution becomes possible by the procedure.

The measuring object of the radiation detection device is preferably positron annihilation gamma rays. The radiation source involves C-11, N-13, O-15, F-18 for PET and Na-22, Ge-68 and the like for positron annihilation lifetime.

The following Examples are provided to illustrate the present invention, but are not intended to limit the scope thereof.

### Preparation 1

BaF₂ crystal doped with Eu was prepared according to Bridgeman-Stockbargar method by the following procedures. First of all, Eu powder for doping was mixed with basic ingredient powder of BaF₂ followed by stirring. The amount of Eu in BaF₂ ingredient was 0.2 mol%.
The mixture was enclosed in the crucible and the crucible was subjected to get slowly down into a vertical furnace (crystal growth furnace) with a specified temperature gradient. The crystal was obtained by solidifying from the bottom of melt in the crucible.

### Preparation 2

In this preparation, a crystal was prepared with 0.02 mol% Eu dope as for preparation 1.

### Example 1

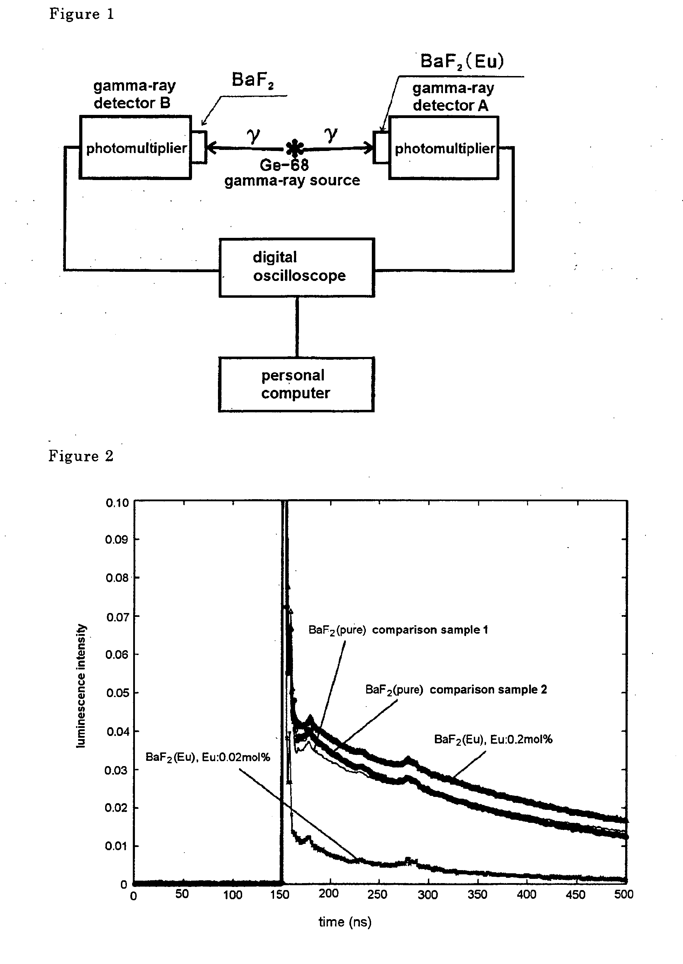

The following Examples used the measuring system shown in Fig.1. The time difference measurement of positron annihilation gamma rays (0.511 MeV) was performed by the use of 68Ge as a radiation source. The output of photomultiplier (Hamamatsu photonics, H3378) was branched into two. One is directly input to high-speed digital oscilloscope (LeCroy WavePro 7100), the other was input into an amplitude discriminator and to coincidence circuit and the oscilloscope was triggered. The measured data was imported into a personal computer and analyzed.

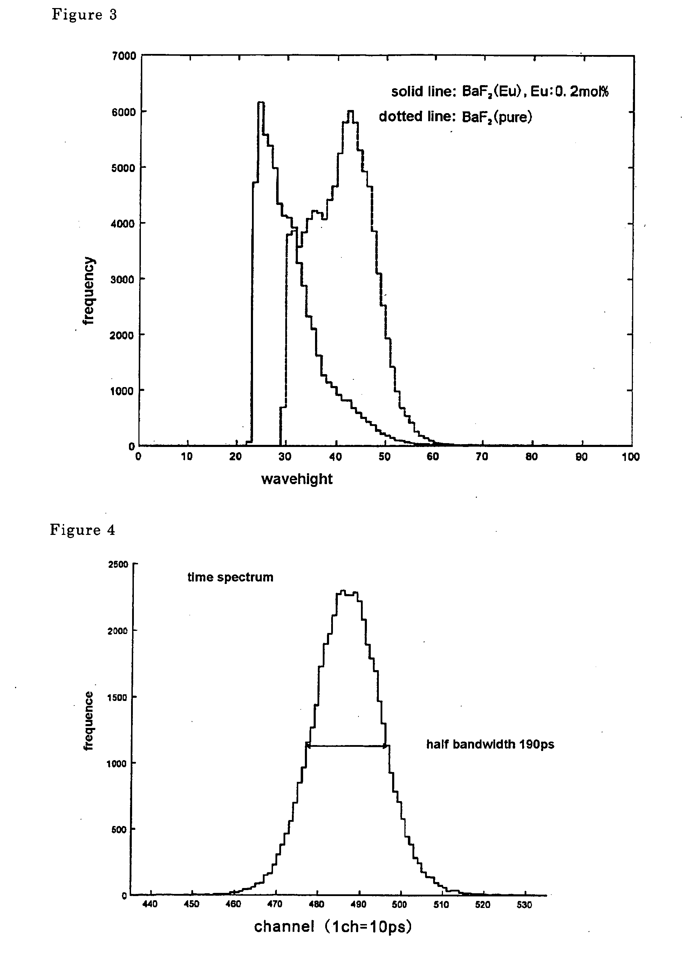

In the present Example, time spectra were measured for the crystals obtained in Preparations 1 and 2 (they are represented as [BaF₂(Eu), Eu:0.2mol%] and [BaF₂(Eu), Eu:0.02mol%], respectively) and BaF₂ crystal (Ohyo Koken Kogyo Co., LTD.) and BaF₂ (Nihon Kesshou Kougaku Co., LTD)(represented as [BaF₂ (pure)]). The results are shown in Fig.2. The long decay lifetime component of BaF₂ (Eu), Eu:0.02mol% is approximately identical to that of BaF₂ (pure). It seems that the effect on reduction of long decay lifetime component in BaF₂ (Eu), Eu:0.02mol% is limited. The long decay lifetime component in BaF₂ (Eu), Eu:0.2mol% is reduced to 1/4 of that in BaF₂ (pure). Moreover, as shown in Fig. 3, the reduction of short decay lifetime component is fixed to about 60%. Therefore, reduction of the luminescence intensity of long decay lifetime component relative to that of short decay lifetime component is about 40% of that in BaF₂ (pure). Consequently, the luminescence in BaF₂ (Eu), Eu:0.2mol% could respond to 2.5 times higher counting rate of that in BaF₂(pure).

### Example 2

Measurements of luminescence intensity and time resolution were performed for BaF₂ (Eu), Eu:0.2mol% crystal obtained in Preparation 2. For comparison, the measurement was performed also for BaF₂ crystal (Nihon Kesshou Kougaku Co., LTD). The results are shown in Fig.3.

As shown in Fig. 3, the luminescence intensity (proportional to wavehight) of fast decaying component in BaF₂ (Eu), Eu:0.2mol% is about 60 hundreds of that in BaF₂ (pure). Worsening of time resolution was fixed around 30 hundreds in contrast to 120 ps for BaF₂. Therefore, the property of the luminescence is in practically usable range.

### Example 3

Barium fluoride (BaF₂) crystal was used for scintillator crystal of one radiation detection device, and the crystal obtained in Preparation 1 or 2 was used for the other radiation detection device in the measuring system shown in Fig.1. Time difference measurement of positron annihilation gamma rays (0.511 MeV) was performed by the use of Ge-68 as a radiation source. The output of photomultiplier (Hamamatsu photonics, H3378) was branched into two. One is directly input to high-speed digital oscilloscope (LeCroy WavePro 7100), the other was input into an amplitude discriminator and to coincidence circuit and the oscilloscope was triggered. The measured data was imported into a personal computer and analyzed. The results are shown in Fig. 4.

The time resolution was 190 ps. Since time resolution of gamma-ray detecting element is 120 ps, the time resolution of gamma-ray detecting element (BaF₂ (Eu), Eu:0.2mol%) is estimated to be (190²-120²)=147 ps≊150 ps.

As described above, the time difference measurement by use of the combination of scintillator of the present invention and digital oscilloscope enables very rapid time resolution and could be applied to radiation measurement required high time resolution such as positron lifetime measurement.

## Claims

1. A high counting rate scintillator for detecting radiation, comprising BaF₂, doped with rare earth elements, wherein the doping amount is in the range of 0.02 to 1.0 mol%.

2. The scintillator of claim 1, wherein said rare earth element is Eu.

3. The scintillator of claim 1 or 2, wherein the relative intensity of the long decay lifetime component with more than 100 ns of said scintillator is less than 50% of the intensity of BaF₂ luminescence.

4. The scintillator of any one of claims 1 to 3, wherein the time resolution of said scintillator is less than 200 ps of half bandwidth.

5. A radiation detection device comprising the scintillator of any one of claims 1 to 4 and a photomultiplier for detecting a luminescence from said scintillator.
